# EUROPEAN PATENT APPLICATION

(11) **EP 2 159 588 A1**
(43) Date of publication of application: **03.03.2010**
(21) Application number: 08765350.7
(22) Date of filing: 09.06.2008
(51) Int. Cl.: G01R 33/09

(54) **MAGNETIC DETECTING DEVICE, METHOD FOR MANUFACTURING MAGNETIC DETECTING DEVICE, AND ANGLE DETECTING DEVICE, POSITION DETECTING DEVICE AND MAGNETIC SWITCH USING THE MAGNETIC DETECTING DEVICE**

(30) Priority: 19.06.2007 JP 2007161163
(71) Applicant: Alps Electric Co., Ltd., Tokyo 145-8501 (JP)
(72) Inventor: ANDO, Hideto, Tokyo 145-8501 (JP); SATO, Kiyoshi, Tokyo 145-8501 (JP)
(74) Representative: Klunker . Schmitt-Nilson . Hirsch
(86) International application number: PCT/JP2008/060560
(87) International publication number: WO 2008/156008

(57) **Abstract**

[Object] An object is to provide, in particular, a magnetic detecting device that has a plurality of chips closely mounted on a substrate and is capable of detecting an external magnetic field with high accuracy, a method for making the magnetic detecting device, and an angle detecting apparatus including the magnetic detecting device.

[Solving Means] Conductive patterns 50, 51, and 52 are formed on a substrate 21 in a surrounding region E outside chips 22 and 23, except for a region between the chips 22 and 23. Inner connection pads 41 formed on each of the chips 22 and 23 are wire-bonded to their corresponding conductive patterns, so that the chips 22 and 23 are electrically connected to each other. It is thus possible to reduce the distance between the chips 22 and 23, place magnetoresistive elements 24 and 25 provided in each of the chips in a small area, and detect a change in external magnetic field with high accuracy.

## Description

### Technical Field

The present invention particularly relates to a magnetic detecting device that has a plurality of chips closely mounted on a substrate and is capable of detecting an external magnetic field with high accuracy, a method for making the magnetic detecting device, and an angle detecting apparatus, a position detecting apparatus, and a magnetic switch each including the magnetic detecting device.

### Background Art

For example, an angle detecting apparatus for detecting a rotation angle of a rotating body can include a magnetoresistive element (GMR element) using a giant magnetoresistive effect (GMR effect).

An electrical resistance of the magnetoresistive element varies in accordance with an external magnetic field. For example, by rotating a magnet as a rotating body that generates an external magnetic field, the direction of an external magnetic field flowing into the magnetoresistive element is changed, so that an electrical resistance value of the magnetoresistive element is changed. On the basis of this change in electrical resistance value, it is possible to detect the rotation angle of the rotating body.

For example, two types of magnetoresistive elements are prepared as the magnetoresistive element described above. These magnetoresistive elements show opposite changes in electrical resistance with respect to a change in magnetic field. By providing a bridge circuit including these two types of magnetoresistive elements, it is possible to increase an output value and detect a change in external magnetic field with high accuracy.

Magnetoresistive elements having different electrical characteristics, as described above, are mounted on different chips.

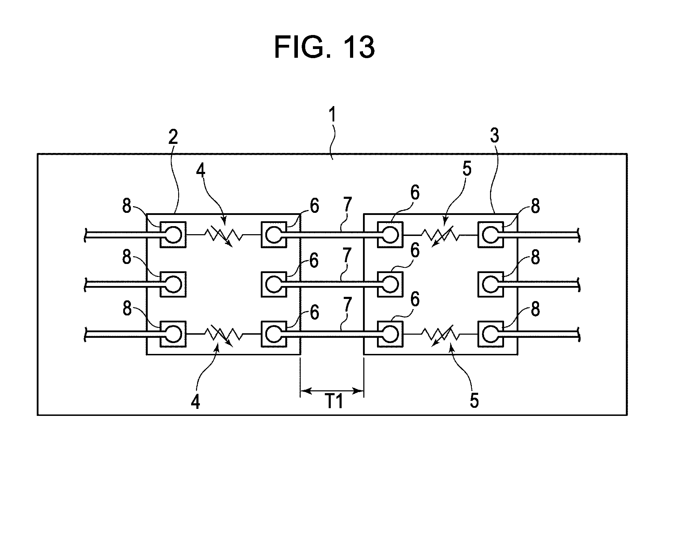

Fig. 13 is a plan view illustrating a conventional magnetic detecting device. A first chip 2 and a second chip 3 are mounted on a substrate 1.

The first chip 2 has two first magnetoresistive elements 4, and the second chip 3 has two second magnetoresistive elements 5. The first magnetoresistive elements 4 and the second magnetoresistive elements 5 show different changes in electrical resistance with respect to a change in magnetic field.

As illustrated in Fig. 13, a plurality of connection pads are exposed on the respective surfaces of the chips 2 and 3. Of the connection pads, inner connection pads 6 arranged on facing sides of the chips 2 and 3 are electrically connected to each other through wires 7 by wire bonding, while outer connection pads 8 are electrically connected to an integrated circuit (IC) (not shown) by wire bonding. A bridge circuit including the first magnetoresistive elements 4 and the second magnetoresistive elements 5 is formed by electrically connecting the inner connection pads 6 on the chips 2 and 3. The outer connection pads 8 each are connected to any of an input terminal, a ground terminal, and an output terminal of the integrated circuit.
Patent Document 1: Japanese Unexamined Patent Application Publication No. 10-93009
Patent Document 2: Japanese Unexamined Patent Application Publication No. 8-264596
Patent Document 3: Japanese Unexamined Patent Application Publication No. 2003-66127

### Disclosure of Invention

### Problems to be Solved by the Invention

In the configuration illustrated in Fig. 13, the inner connection pads 6 on the chips 2 and 3 are directly wire-bonded to each other. In this case, to form each of the wires 7 into a loop and properly connect it onto each of the inner connection pads 6 facing each other, it is necessary to leave a certain distance T1 between the chips 2 and 3.

However, when the distance T1 between the chips 2 and 3 increases, horizontal magnetic field components of an external magnetic field generated by a magnet and acting on each of the first magnetoresistive elements 4 and the second magnetoresistive elements 5 are reduced. This makes it difficult to detect a change in external magnetic field with high accuracy. To detect a change in external magnetic field with high accuracy, it is necessary to reduce the distance T1 between the chips 2 and 3.

Additionally, in the configuration of Fig. 13 where the inner connection pads 6 on the chips 2 and 3 are directly wire-bonded to each other, it is necessary that the inner connection pads 6 to which the wires are secondly bonded be larger in size. Since the wires are pressed and flattened in the second bonding, it is necessary that the inner connection pads 6 to which the wires are secondly bonded be larger in size than the inner connection pads 6 to which the wires are firstly bonded. This results in an increased distance between the first magnetoresistive elements 4 and the second magnetoresistive elements 5 and degraded accuracy in magnetic field detection.

For example, Patent Document 1 and Patent Document 2 each disclose a configuration in which a conductive pattern for relaying purposes is provided between chips. In this configuration, the conductive pattern and connection pads on one of the chips are wire-bonded to each other, and the conductive pattern and connection pads on the other chip are also wire-bonded to each other.

With this configuration, if the second bonding is performed on the conductive pattern, it is not necessary that the connection pads on one of the chip be larger in size.

However, since it is necessary to provide an area for the conductive pattern between the chips, it is difficult to reduce the distance between the chips. Even if a wiring configuration using the conductive pattern described in Patent Document 1 and Patent Document 2 is applied to the magnetic detecting device described above, it is difficult to properly reduce the distance between the first magnetoresistive elements and the second magnetoresistive elements, and thus to detect a magnetic field with high accuracy.

The present invention has been made to solve the conventional problems described above. In particular, the present invention aims to provide a magnetic detecting device that has a plurality of chips closely mounted on a substrate and is capable of detecting an external magnetic field with high accuracy, a method for making the magnetic detecting device, and an angle detecting apparatus, a position detecting apparatus, and a magnetic switch each including the magnetic detecting device.

### Means for Solving the Problems

According to the present invention, a magnetic detecting device includes a substrate and a plurality of chips mounted on the substrate. The chips each are provided with connection pads and magnetic detecting elements having an electrical characteristic changing in accordance with a magnetic field change. The magnetic detecting device detects the magnetic field change on the basis of a change in the electrical characteristic. In the magnetic detecting device, conductive patterns are formed on the substrate in a surrounding region outside the chips, except for a region between the chips. The connection pads of each of the chips include first connection pads for electrically connecting the chips. The first connection pads are wire-bonded to their corresponding conductive patterns, and thereby the chips are electrically connected to each other.

With the configuration described above, it is possible to reduce the distance between the chips, place the magnetic detecting elements in a small area, and detect a change in magnetic field with high accuracy.

The present invention is effectively applicable to a configuration in which the first connection pads are arranged on facing sides of the chips electrically connected to each other.

In the magnetic detecting device of the present invention, it is preferable that each wire for the wire bonding be bonded onto each of the first connection pads and its corresponding conductive pattern, and a region on the first connection pad be a first bonding region onto which the wire is firstly bonded and a region on the conductive pattern be a second bonding region onto which the wire is secondly bonded. Thus, it is possible to properly reduce the size of the first connection pads, and place the magnetic detecting elements in a smaller area.

In the magnetic detecting device of the present invention, it is preferable that a pair of electrically-connected chips each include a magnetoresistive element using a magnetoresistive effect and having a fixed magnetic layer and a free magnetic layer that are stacked with a nonmagnetic material layer interposed therebetween, the fixed magnetic layer having a fixed magnetization direction, the free magnetic layer having a magnetization direction varying in accordance with an external magnetic field; and the magnetization direction in the fixed magnetic layer of the magnetoresistive element in one of the chips be antiparallel to the magnetization direction in the fixed magnetic layer of the magnetoresistive element in the other chip. Thus, with a simple configuration, it is possible to increase an output value relative to a change in external magnetic field, and thus to detect a change in external magnetic field with higher accuracy.

An angle detecting apparatus according to the present invention includes any of the magnetic detecting devices described above, and a magnetic-field generating member facing the magnetic detecting device in a height direction of the substrate and configured to generate an external magnetic field. In the angle detecting apparatus, at least one of the magnetic detecting device and the magnetic-field generating member is supported so as to be rotatable about a rotation axis extending in the height direction of the substrate. A rotation angle is detected on the basis of an output change associated with a magnetic field change detected by the magnetic detecting device.

The present invention makes it possible to reduce the distance between the chips and place the magnetic detecting elements in a small area. Thus, it is possible to increase horizontal magnetic field components of an external magnetic field generated by the magnetic-field generating member and acting on each of the magnetic detecting elements, and thus to detect a rotation angle with high accuracy. Additionally, the present invention makes it possible to reduce the size of the magnetic-field generating member and thus to provide the angle detecting apparatus that is small in size.

A position detecting apparatus according to the present invention includes any of the magnetic detecting devices described above, and a magnetic-field generating member facing the magnetic detecting device in a height direction of the substrate and configured to generate an external magnetic field. In the position detecting apparatus, the magnetic detecting device has moving components in a direction orthogonal to the height direction and is supported movably relative to the magnetic-field generating member. A position of the magnetic detecting device relative to the magnetic-field generating member is detected on the basis of an output change associated with a magnetic field change detected by the magnetic detecting device.

A magnetic switch according to the present invention includes any of the magnetic detecting devices described above, and a magnetic-field generating member facing the magnetic detecting device in a height direction of the substrate and configured to generate an external magnetic field. In the magnetic switch, at least one of the magnetic detecting device and the magnetic-field generating member is supported such that a distance between the magnetic detecting device and the magnetic-field generating member is variable. An ON signal or an OFF signal is generated on the basis of an output change associated with a magnetic field change detected by the magnetic detecting device.

According to the present invention, there is provided a method for making a magnetic detecting device including a substrate and a plurality of chips mounted on the substrate, the chips each being provided with connection pads and magnetic detecting elements having an electrical characteristic changing in accordance with a magnetic field change, the magnetic detecting device being capable of detecting the magnetic field change on the basis of a change in the electrical characteristic. The method for making the magnetic detecting device includes the steps of (a) forming conductive patterns on the substrate in a surrounding region outside chip mounting regions, except for a region between the chip mounting regions; (b) mounting the chips on their corresponding chip mounting regions; and (c) electrically connecting the chips by wire-bonding first connection pads to their corresponding conductive patterns, the first connection pads being included in the connection pads of each of the chips and provided for electrically connecting the chips.

Thus, it is possible to easily and properly make a magnetic detecting device in which chips are closely mounted and magnetic detecting elements are placed in a small area, the magnetic detecting device being capable of detecting a change in magnetic field with high accuracy.

In the present invention, it is preferable, in the wire bonding in the step (c), that each wire be firstly bonded onto one of the first connection pads, secondly bonded onto the conductive pattern corresponding to the first connection pad, and cut. Thus, it is possible to reduce the size of the first connection pads and place the magnetic detecting elements in a smaller area.

### Advantages

In the magnetic detecting device according to the present invention, it is possible to reduce the distance between a plurality of chips mounted on a substrate, and detect a change in magnetic field with high accuracy.

The angle detecting apparatus, the position detecting apparatus, and the magnetic switch each including the magnetic detecting device are capable of detecting a magnetic field with high accuracy. Since the size of the magnetic-field generating member can be reduced, it is possible to provide the angle detecting apparatus, the position detecting apparatus, and the magnetic switch that are small in size.

### Best Modes for Carrying Out the Invention

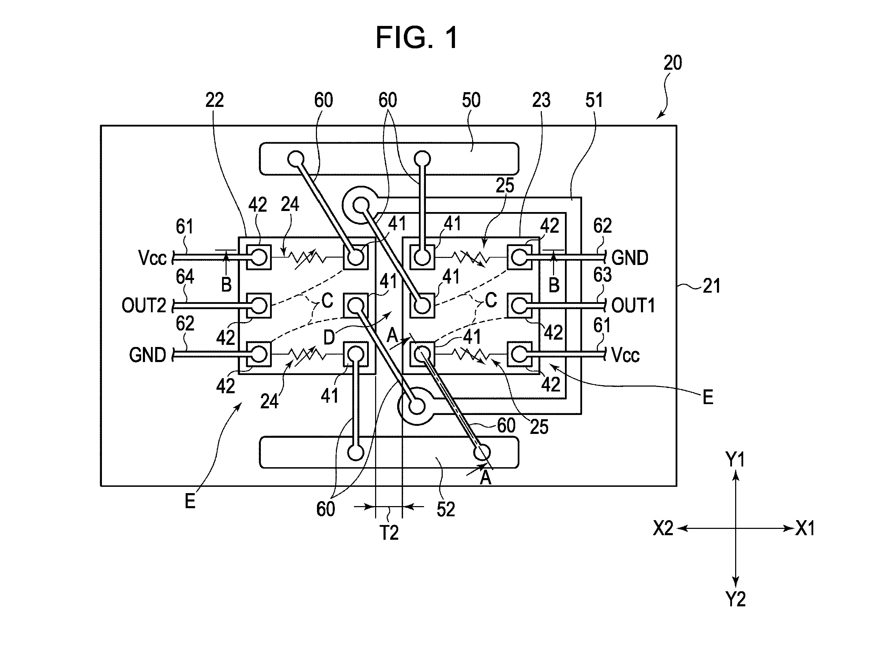

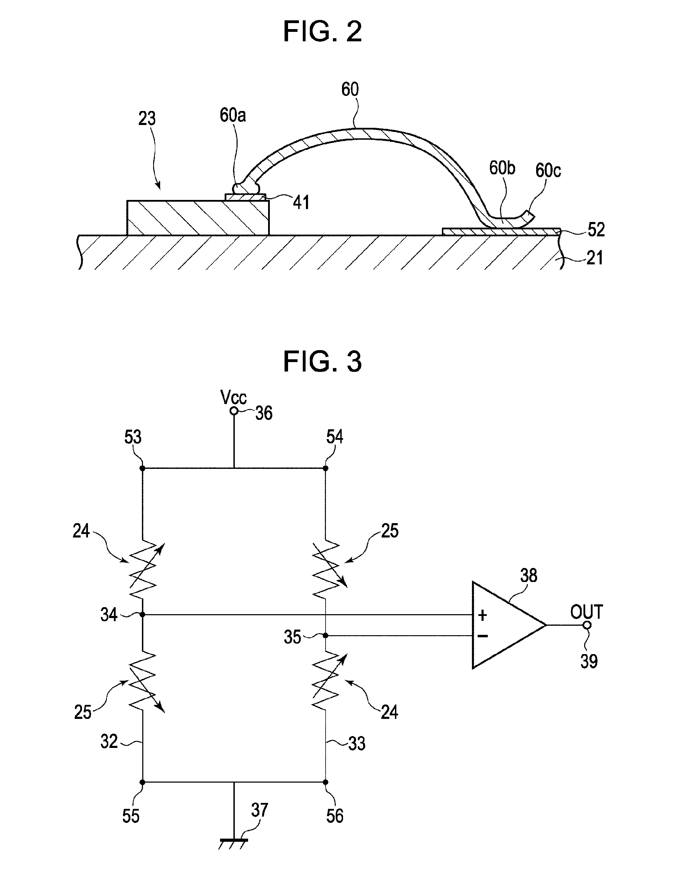

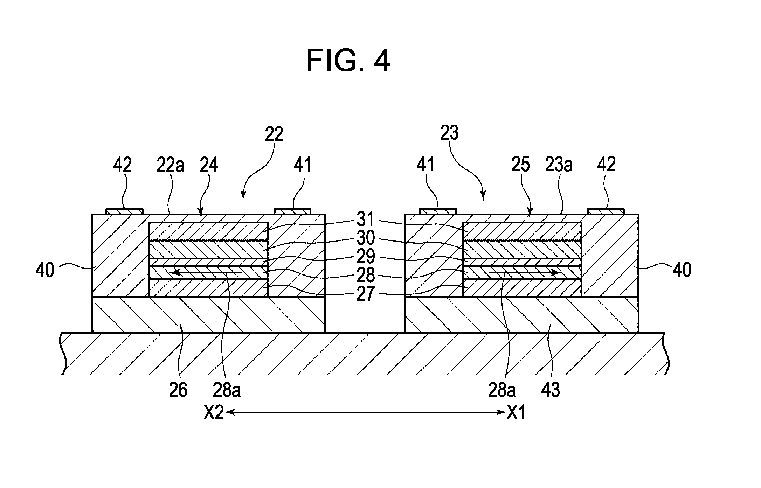

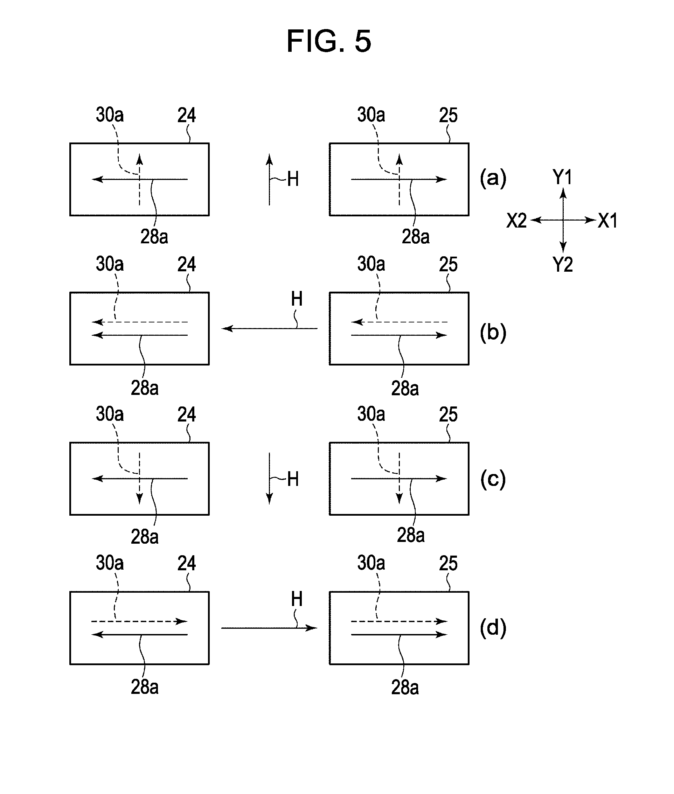

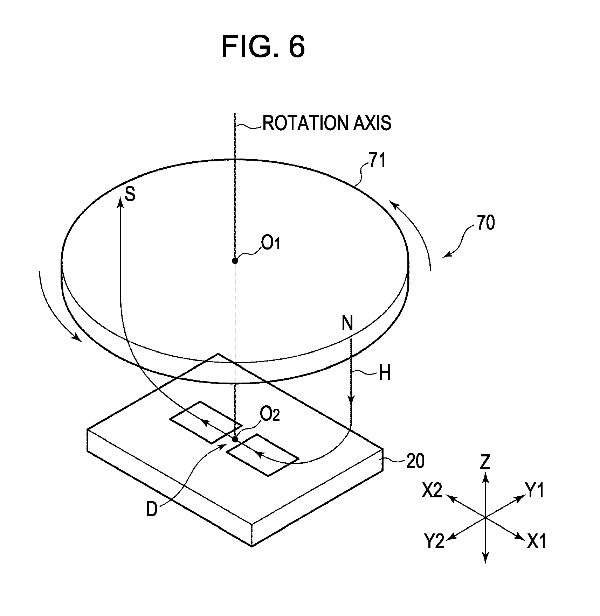

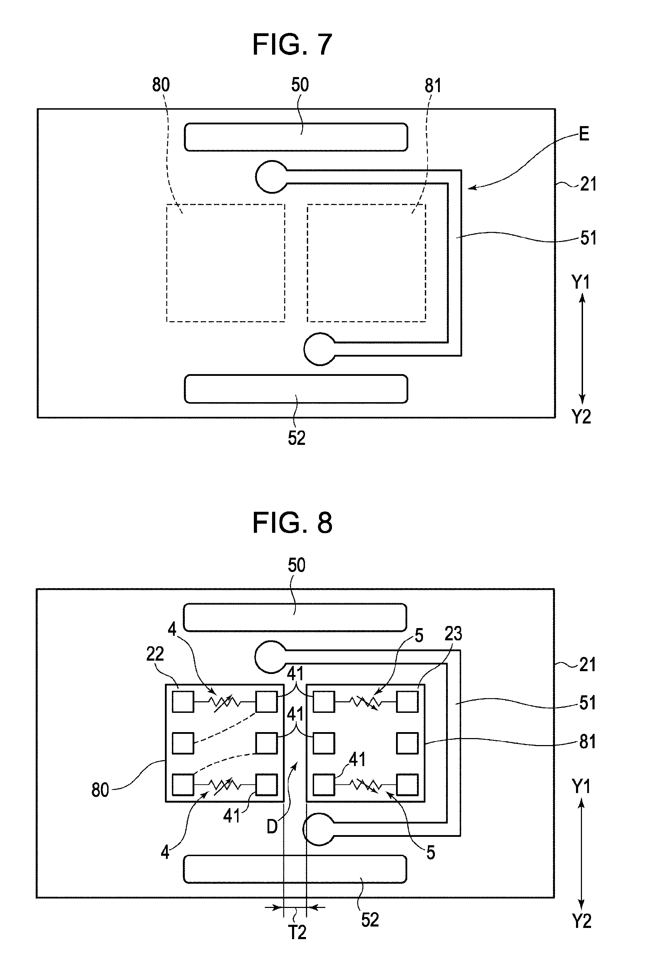

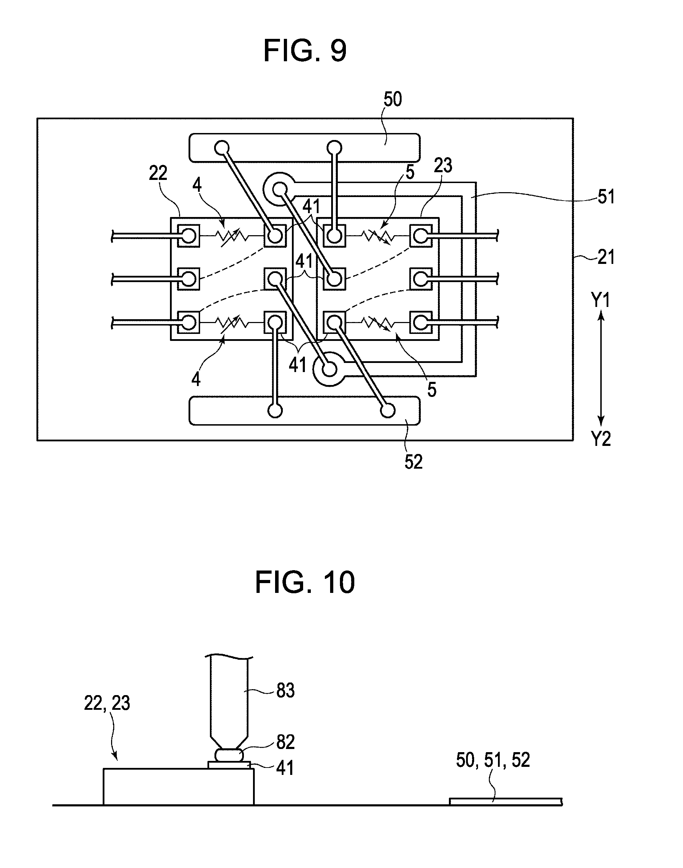

Fig. 1 is a plan view of a magnetic detecting device according to the present embodiment. Fig. 2 is a partial enlarged cross-sectional view taken along line A-A of Fig. 1 in a height direction of the magnetic detecting device, the view showing a cross section of the magnetic detecting device as viewed from the direction of arrows. Fig. 3 illustrates a circuit configuration of the magnetic detecting device according to the present embodiment. Fig. 4 is a partial enlarged cross-sectional view taken along line B-B of Fig. 1 in the height direction of the magnetic detecting device, the view showing a cross section of the magnetic detecting device as viewed from the direction of arrows. Fig. 5(a) to Fig. 5(d) schematically illustrate magnetization directions in a fixed magnetic layer and a free magnetic layer of both a first magnetoresistive element and a second magnetoresistive element, the magnetization directions being associated with changes in direction of an external magnetic field. Fig. 6 is a perspective view of an angle detecting apparatus according to the present embodiment. Fig. 7 to Fig. 9 are plan views each illustrating a step of making the magnetic detecting device according to the present embodiment. Fig. 10 to Fig. 12 are enlarged side views illustrating wire bonding in the present embodiment.

As illustrated in Fig. 1, in a magnetic detecting device 20 of the present embodiment, a first chip 22 and a second chip 23 are mounted on a substrate 21. Each of the chips 22 and 23 is about 0.3 mm to 3 mm in width (i.e., dimension in an X1-X2 direction of Fig. 1), and about 0.3 mm to 3 mm in length (i.e., dimension in a Y1-Y2 direction of Fig. 1).

As illustrated in Fig. 1, the first chip 22 is provided with two first magnetoresistive elements 24, and the second chip 23 is provided with two second magnetoresistive elements 25.

As illustrated in Fig. 4, the first magnetoresistive element 24 and the second magnetoresistive element 25 are formed on different bases 26.

The first magnetoresistive elements 24 and the second magnetoresistive elements 25 are magnetoresistive elements (GMR elements) using a giant magnetoresistive effect (GMR effect). As illustrated in Fig. 4, the first magnetoresistive element 24 and the second magnetoresistive element 25 each have an antiferromagnetic layer 27, a fixed magnetic layer 28, a nonmagnetic material layer 29, a free magnetic layer 30, and a protective layer 31 stacked in this order from the bottom. The antiferromagnetic layer 27 is made of, for example, IrMn. The fixed magnetic layer 28 and the free magnetic layer 30 are made of ferromagnetic material, such as NiFe or CoFe. The nonmagnetic material layer 29 is made of, for example, Cu. The protective layer 31 is made of, for example, Ta.

As illustrated in Fig. 4, a magnetization direction 28a in the fixed magnetic layer 28 of the first magnetoresistive element 24 is the X2 direction in the drawing, while the magnetization direction 28a in the fixed magnetic layer 28 of the second magnetoresistive element 25 is the X1 direction in the drawing. That is, the magnetization direction 28a in the fixed magnetic layer 28 of the first magnetoresistive element 24 and the magnetization direction 28a in the fixed magnetic layer 28 of the second magnetoresistive element 25 are different by 180 degrees (i.e., antiparallel to each other).

As illustrated in Fig. 3, the two first magnetoresistive elements 24 and the two second magnetoresistive elements 25 form a bridge circuit. As illustrated in Fig. 3, the first magnetoresistive element 24 and the second magnetoresistive element 25 that constitute a first series circuit 32 are connected to an input terminal 36 and a ground terminal 37, respectively. The second magnetoresistive element 25 and the first magnetoresistive element 24 that constitute a second series circuit 33 are connected to the input terminal 36 and the ground terminal 37, respectively. As illustrated in Fig. 3, an output extracting portion 34 of the first series circuit 32 and an output extracting portion 35 of the second series circuit 33 are both connected to a differential amplifier 38, whose output end is connected to an output terminal 39.

When the magnetization direction 28a in the fixed magnetic layer 28 of the first magnetoresistive element 24 and the magnetization direction 28a in the fixed magnetic layer 28 of the second magnetoresistive element 25 are antiparallel to each other as illustrated in Fig. 4, changes in electrical resistance values of the first magnetoresistive element 24 and the second magnetoresistive element 25 with respect to an external magnetic field H have a phase difference of 180 degrees relative to a rotating magnetic field. The explanation will now be given with reference to Fig. 5.

In Fig. 5(a), the external magnetic field H is directed in the Y1 direction. Magnetization directions 30a in the free magnetic layers 30 of the first magnetoresistive element 24 and second magnetoresistive element 25 are both directed in the Y1 direction. As illustrated in Fig. 5(a), in both the first magnetoresistive element 24 and the second magnetoresistive element 25, the magnetization direction 28a in the fixed magnetic layer 28 and the magnetization direction 30a in the free magnetic layer 30 are orthogonal to each other. This means that the first magnetoresistive element 24 and the second magnetoresistive element 25 have the same electrical resistance value.

Next, when the external magnetic field H turns 90 degrees counterclockwise, the external magnetic field H is directed in the X2 direction, as illustrated in Fig. 5(b). The magnetization directions 30a in the free magnetic layers 30 are also directed in the X2 direction. As illustrated in Fig. 5(b), in the first magnetoresistive element 24, the magnetization direction 28a in the fixed magnetic layer 28 and the magnetization direction 30a in the free magnetic layer 30 are parallel to each other. Therefore, in the state of Fig. 5(b), the electrical resistance value of the first magnetoresistive element 24 is minimum. On the other hand, as illustrated in Fig. 5(b), in the second magnetoresistive element 25, the magnetization direction 28a in the fixed magnetic layer 28 and the magnetization direction 30a in the free magnetic layer 30 are antiparallel to each other. Therefore, in the state of Fig. 5(b), the electrical resistance value of the second magnetoresistive element 25 is maximum. Thus, during the transition from the state of Fig. 5(a) to the state of Fig. 5(b), the electrical resistance value of the first magnetoresistive element 24 gradually decreases to a minimum, while the electrical resistance value of the second magnetoresistive element 25 gradually increases to a maximum.

When the external magnetic field H further turns 90 degrees counterclockwise, the external magnetic field H is directed in the Y2 direction, as illustrated in Fig. 5(c). The magnetization directions 30a in the free magnetic layers 30 are also directed in the Y2 direction. The state of Fig. 5(c) is the same as that of Fig. 5(a) in that in both the first magnetoresistive element 24 and the second magnetoresistive element 25, the magnetization direction 28a in the fixed magnetic layer 28 and the magnetization direction 30a in the free magnetic layer 30 are orthogonal to each other, and thus the electrical resistance values of the first magnetoresistive element 24 and second magnetoresistive element 25 are the same. During the transition from the state of Fig. 5(b) to the state of Fig. 5(c), the electrical resistance value of the first magnetoresistive element 24 gradually increases, while the electrical resistance value of the second magnetoresistive element 25 gradually decreases.

When the external magnetic field H further turns 90 degrees counterclockwise, the external magnetic field H is directed in the X1 direction, as illustrated in Fig. 5(d). The magnetization directions 30a in the free magnetic layers 30 are also directed in the X1 direction. As illustrated in Fig. 5(d), in the first magnetoresistive element 24, the magnetization direction 28a in the fixed magnetic layer 28 and the magnetization direction 30a in the free magnetic layer 30 are antiparallel to each other. Therefore, in the state of Fig. 5(d), the electrical resistance value of the first magnetoresistive element 24 is maximum. On the other hand, as illustrated in Fig. 5(d), in the second magnetoresistive element 25, the magnetization direction 28a in the fixed magnetic layer 28 and the magnetization direction 30a in the free magnetic layer 30 are parallel to each other. Therefore, in the state of Fig. 5(d), the electrical resistance value of the second magnetoresistive element 25 is minimum. Thus, during the transition from the state of Fig. 5(c) to the state of Fig. 5(d), the electrical resistance value of the first magnetoresistive element 24 gradually increases to a maximum, while the electrical resistance value of the second magnetoresistive element 25 gradually decreases to a minimum.

As described above, changes in electrical resistance values of the first magnetoresistive element 24 and the second magnetoresistive element 25 with respect to the external magnetic field H have a phase difference of 180 degrees relative to a rotating magnetic field. Therefore, by providing a bridge circuit including the first magnetoresistive elements 24 and the second magnetoresistive elements 25 as illustrated in Fig. 3, an output value (differential potential) can be doubled, as compared to the case where the first magnetoresistive elements 24 or the second magnetoresistive elements 25 are fixed resistive elements.

As illustrated in Fig. 4, the first magnetoresistive element 24 and the second magnetoresistive element 25 each are covered with a cover layer 40 of resin, inorganic insulating material, or the like and formed into a package. As illustrated in Fig. 1 and Fig. 4, conductive connection pads 41 and 42 are exposed externally on each of chip surfaces 22a and 23a of the first chip 22 and the second chip 23, respectively. Three connection pads 41 and three connection pads 42 are provided on each of the chips 22 and 23.

The connection pads 41 and 42 are directly or indirectly electrically connected to their corresponding magnetoresistive elements 24 and 25. In Fig. 1, dotted lines C represent wiring inside the chips 22 and 23.

In the present embodiment, the first chip 22 and the second chip 23 have the same chip configuration. The second chip 23 is turned 180 degrees from the orientation of the first chip 22 and placed on the substrate 21. Thus, as described with reference to Fig. 4, the magnetization direction 28a in the fixed magnetic layer 28 of the first magnetoresistive element 24 formed in the first chip 22 and the magnetization direction 28a in the fixed magnetic layer 28 of the second magnetoresistive element 25 formed in the second chip 23 can be made antiparallel to each other. When the first chip 22 and the second chip 23 have the same chip configuration as described above, it is possible to form the first chip 22 and the second chip 23 on the same substrate. Alternatively, the first chip 22 and the second chip 23 can be formed separately with different chip configurations.

Of the connection pads 41 and 42, the connection pads 41 (first connection pads) are arranged on facing sides of the chips 22 and 23, while the connection pads 42 (second connection pads) are arranged on opposite sides of the connection pads 41. Hereinafter, the connection pads 41 will be referred to as the inner connection pads 41 and the connection pads 42 will be referred to as the outer connection pads 42.

As illustrated in Fig. 1, a facing region D is provided between the first chip 22 and the second chip 23. It is preferable that a distance T2 of the facing region D be within the range of 0.1 mm to 0.5 mm. In particular, if wiring requirements etc. are met, it is most preferable that the distance T2 of the facing region D be zero, that is, the first chip 22 and the second chip 23 be in contact with each other.

As illustrated in Fig. 1, in the present embodiment, conductive patterns 50, 51, and 52 are formed on the substrate 21 in a surrounding region E outside the chips 22 and 23, except for the region between the chips 22 and 23. That is, the conductive patterns are not formed in the facing region D on the substrate 21 and are formed in the other regions on the substrate 21.

As illustrated in Fig. 1, the inner connection pads 41 formed at corners on the Y1 side of the first chip 22 and the second chip 23 are both wire-bonded to the conductive pattern 50, so that the inner connection pads 41 on the Y1 side are electrically connected to each other. Also, the inner connection pads 41 formed at corners on the Y2 side of the first chip 22 and the second chip 23 are both wire-bonded to the conductive pattern 52, so that the inner connection pads 41 on the Y2 side are electrically connected to each other. Similarly, the inner connection pads 41 located in the middle of the first chip 22 and the second chip 23 in the Y direction are both wire-bonded to the conductive pattern 51, so that the inner connection pads 41 located in the middle are electrically connected to each other.

Wires 60 for wire bonding are made of material having good electrical conductivity, such as metal. As illustrated in Fig. 2, the wire 60 is bonded onto the inner connection pad 41 at one end and onto the conductive pattern 51 at the other end. As illustrated in Fig. 2, it is preferable that a region on the inner connection pad 41 be a first bonding region onto which the wire 60 is firstly bonded, and a region on the conductive pattern 52 be a second bonding region onto which the wire 60 is secondly bonded.

As illustrated in Fig. 2, a first bonding portion 60a of the wire 60 is located in the first bonding region on the inner connection pad 41, and a second bonding portion 60b of the wire 60 is located in the second bonding region on the conductive pattern 52. The first bonding portion 60a has a flattened shape obtained by pressing an originally ball-shaped portion with a capillary. The second bonding portion 60b is formed by flattening the wire 60. In the second bonding, a portion where the wire 60 is firmly bonded onto the conductive pattern 60 and a temporary bonding region for allowing the wire 60 to be easily cut at a predetermined position are formed. Therefore, the bonding region of the second bonding portion 60b is larger than that of the first bonding portion 60a. A wire end face 60c adjacent to the second bonding portion 60b is a cut end of the wire 60. Thus, looking at the shape of the wire 60 makes it possible to determine which of the inner connection pad 41 and the conductive pattern 52 corresponds to which of the first bonding region and the second bonding region.

The second bonding portion 60b of the wire 60 is formed in a region larger than that for the first bonding portion 60a. However, in the present embodiment, since the first bonding region is on the inner connection pad 41, the size of the inner connection pad 41 can be reduced. It is thus possible to reduce the size of the chips 22 and 23.

By electrically connecting the inner connection pads 41 and 41 on the first chip 22 and the second chip 23 as illustrated in Fig. 1, the bridge circuit illustrated in Fig. 3 is formed.

In the embodiment illustrated in Fig. 1, every inner connection pad 41 is wire-bonded onto one of the conductive patterns 50, 51, and 52 for connection between the chips. Alternatively, for example, only some of the inner connection pads 41 may be used for connection between the chips.

Each of the outer connection pads 42 on the chips 22 and 23 corresponds to any of input-side connection points 53 and 54 connected to the input terminal 36, ground-side connection points 55 and 56 connected to the ground terminal 37, and the output extracting portions 34 and 35. The outer connection pads 42 are electrically connected to the input terminal 36, the ground terminal 37, and the input end of the differential amplifier 38 by wire bonding. Fig. 1 shows an example. In Fig. 1, "Vcc" indicates that a wire 61 is connected to the input terminal 36, "GND" indicates that a wire 62 is connected to the ground terminal 37, "OUT1" indicates that the connection pad 42 to which a wire 63 is connected is the output extracting portion 34, and "OUT2" indicates that the connection pad 42 to which a wire 64 is connected is the output extracting portion 35.

The magnetic detecting device 20 of the present embodiment described above can be included in an angle detecting apparatus 70 illustrated in Fig. 6. The angle detecting apparatus 70 includes a magnetic-field generating member 71 that is opposite the magnetic detecting device 20 in a height direction (Z direction). There is a space between the magnetic detecting device 20 and the magnetic-field generating member 71, and the magnetic detecting device 20 serves as a non-contact magnetic sensor.

The magnetic-field generating member 71 is supported such that it can rotate about a rotation axis extending in the height direction (Z direction). The north pole of the magnet is at one end of a line passing through a rotation center O1 of the magnetic-field generating member 71, and the south pole of the magnet is located at the other end of this line. The magnetic-field generating member 71 may include a rotating body and a plurality of magnets arranged on a surface of the rotating body opposite the magnetic detecting device 20. Alternatively, the magnetic-field generating member 71 itself may be a magnet.

When the magnetic-field generating member 71 rotates above the magnetic detecting device 20, the external magnetic field H acts on each of the first magnetoresistive element 24 and the second magnetoresistive element 25 as the rotating magnetic field, which has been described with reference to Fig. 5. This causes changes in the magnetization directions 30a in the free magnetic layers 30 of the first magnetoresistive element 24 and second magnetoresistive element 25, and thus causes changes in the electrical resistance values of the first magnetoresistive element 24 and second magnetoresistive element 25. The circuit illustrated in Fig. 3 provides an output value (differential potential) based on changes in the electrical resistance values. On the basis of this output value, a rotation angle of the magnetic-field generating member 71 can be detected.

As the magnetic-field generating member 71 rotates as illustrated in Fig. 6, horizontal magnetic field components in a plane defined by the X1-X2 direction and the Y1-Y2 direction act on each of the first magnetoresistive element 24 and the second magnetoresistive element 25. Thus, as illustrated in Fig. 5, the magnetization directions 30a in the free magnetic layers 30 change toward the external magnetic field H of the horizontal magnetic field components.

For example, as illustrated in Fig. 6, at the edge of the magnetic-field generating member 71, the external magnetic field H has many vertical magnetic field components parallel to the Z direction. Even when the vertical magnetic field components act on the first magnetoresistive element 24 and the second magnetoresistive element 25, the magnetization directions 30a in the free magnetic layers 30 do not change.

Therefore, unless the configuration is made such that the number of horizontal magnetic field components that act on the first magnetoresistive element 24 and the second magnetoresistive element 25 increases, it is difficult to properly detect the rotation angle of the magnetic-field generating member 71.

In the present embodiment, as described with reference to Fig. 1, the conductive patterns 50, 51, and 52 for relaying wire bonding that provides electrical connections between the inner connection pads 41 on the chips 22 and 23 are formed on the substrate 21 in the surrounding region E outside the chips 22 and 23, except for the region between the chips 22 and 23. Therefore, it is possible to minimize the facing region D between the chips 22 and 23. As a result, the first magnetoresistive elements 24 in the first chip 22 and the second magnetoresistive elements 25 in the second chip 23 can be placed in a small area.

As illustrated in Fig. 6, the intensity of horizontal magnetic field components of the external magnetic field H is higher near the rotation axis. Therefore, by placing the first magnetoresistive elements 24 and the second magnetoresistive elements 25 near the rotation axis, the intensity of the horizontal magnetic field components acting on the first magnetoresistive elements 24 and the second magnetoresistive elements 25 can be increased. It is thus possible to detect the rotation angle of the magnetic-field generating member 71 with high accuracy.

Moreover, even if the size of the magnetic-field generating member 71 is reduced, it is still possible to allow the horizontal magnetic field components to properly act on the first magnetoresistive elements 24 and the second magnetoresistive elements 25. Therefore, it is possible to provide the magnetic-field generating member 71 that has a small size and excellent accuracy in the detection of rotation.

It is preferable that the rotation center O1 of the magnetic-field generating member 71 and a center 02 of the facing region D between the chips 22 and 23 of the magnetic detecting device 20 be placed on the rotation axis, as illustrated in Fig. 6. This is because the first magnetoresistive elements 24 and the second magnetoresistive elements 25 can be effectively placed near the rotation axis.

The angle detecting apparatus 70 of the present embodiment can be used as an in-vehicle angle detecting sensor, such as a throttle position sensor or an accelerator position sensor.

The magnetic detecting device 20 of the present embodiment may be included in a position detecting sensor for an input device, such as a joystick. The position detecting sensor includes the magnetic detecting device 20 and a magnetic-field generating member. The magnetic-field generating member faces the magnetic detecting device 20 in the height direction of the substrate 21 and generates an external magnetic field. The magnetic detecting device 20 has moving components in a direction orthogonal to the height direction of the substrate 21. Then, the magnetic detecting device 20 is supported such that it can move relative to the magnetic-field generating member. A position of the magnetic detecting device 20 relative to the magnetic-field generating member is detected on the basis of an output change associated with a magnetic field change detected by the magnetic detecting device 20.

The magnetic detecting device 20 of the present embodiment may be used as a magnetic switch. The magnetic switch includes the magnetic detecting device 20 and a magnetic-field generating member. The magnetic-field generating member faces the magnetic detecting device 20 in the height direction of the substrate 21 and generates an external magnetic field. At least one of the magnetic detecting device 20 and the magnetic-field generating member is supported such that a distance between the magnetic detecting device 20 and the magnetic-field generating member is variable. On the basis of an output change associated with a magnetic field change detected by the magnetic detecting device 20, an ON signal or an OFF signal is generated.

Although the magnetic-field generating member 71 is rotatably supported in Fig. 6, the magnetic detecting device 20 may be rotatably supported, or both the magnetic-field generating member 71 and the magnetic detecting device 20 may be rotatably supported.

A method for making the magnetic detecting device 20 illustrated in Fig. 1 will now be described with reference to Fig. 7 to Fig. 12.

In a step illustrated in Fig. 7, the conductive patterns 50, 51, and 52 are formed on the substrate 21 in the surrounding region E outside chip mounting regions 80 and 81, except for the region between the mounting regions 80 and 81. The conductive patterns 50, 51, and 52 are formed by an existing method, such as screen printing, plating, or evaporation.

The number of the conductive patterns is the same as the number of connections between the inner connection pads 41 on the chips 22 and 23. Since the number of connections is three in this embodiment, three conductive patterns are formed.

In a step illustrated in Fig. 8, the first chip 22 and the second chip 23 are secured onto the chip mounting regions 80 and 81, respectively, with an adhesive layer interposed. The first chip 22 and the second chip 23 have the same chip configuration, but the second chip 23 is turned 180 degrees from the orientation of the first chip 22 and placed on the substrate 21. Thus, as described with reference to Fig. 4, the magnetization direction 28a in the fixed magnetic layer 28 of the first magnetoresistive element 24 formed in the first chip 22 and the magnetization direction 28a in the fixed magnetic layer 28 of the second magnetoresistive element 25 formed in the second chip 23 can be made antiparallel to each other.

As illustrated in Fig. 8, since no conductive pattern is formed in the facing region D between the chips 22 and 23, the distance T2 of the facing region D can be minimized, as long as wiring requirements etc. are met.

As illustrated in Fig. 8, the first chip 22 and the second chip 23 are mounted on the substrate 21, with the connection pads 41 (first connection pads) directed toward the facing region D.

In a step illustrated in Fig. 9, the inner connection pads 41 on the first chip 22 and the second chip 23 are wire-bonded onto the predetermined conductive patterns 50, 51, and 52.

As illustrated in Fig. 9, the inner connection pads 41 and 41 formed at corners on the Y1 side of the first chip 22 and the second chip 23 are both wire-bonded to the conductive pattern 50, so that the inner connection pads 41 and 41 on the Y1 side are electrically connected to each other. Also, the inner connection pads 41 and 41 formed at corners on the Y2 side of the first chip 22 and the second chip 23 are both wire-bonded to the conductive pattern 52, so that the inner connection pads 41 and 41 on the Y2 side are electrically connected to each other. Similarly, the inner connection pads 41 and 41 located in the middle of the first chip 22 and the second chip 23 in the Y direction are both wire-bonded to the conductive pattern 51, so that the inner connection pads 41 and 41 located in the middle are electrically connected to each other.

A wire bonding method will now be described. As illustrated in Fig. 10, with a gold ball 82 formed at a wire end, a capillary 83 is lowered toward the inner connection pad 41 formed on the surface of the first chip 22 or the second chip 23. Then, heat, load, and ultrasound are applied to the gold ball 82. The gold ball 82 is flattened into the first bonding portion 60a (see Fig. 2), which allows bonding between the wire 60 and the inner connection pad 41.

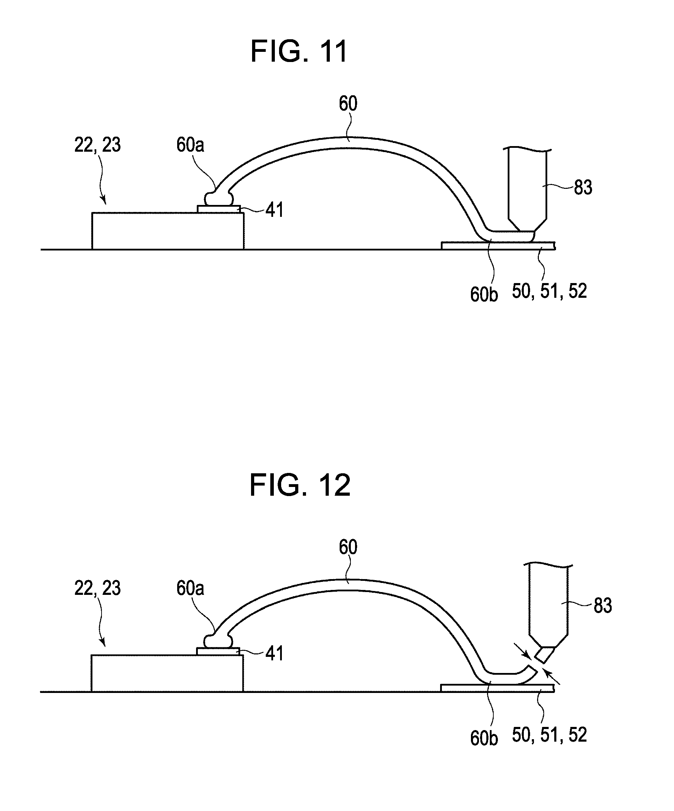

Next, in a step illustrated in Fig. 11, the capillary 83 is raised and moved to a position above the conductive pattern 50, 51, or 52, which is to be bonded subsequently. At the same time, the wire 60 is formed into a loop.

The capillary 83 presses the wire 60 against the conductive pattern 50, 51, or 52 and applies heat, load, and ultrasound to the wire 60, so that the wire 60 is flattened and deformed. In the second bonding, a portion where the wire 60 is firmly bonded onto the conductive pattern 50, 51, or 52, and a temporary bonding region for allowing the wire 60 to be easily cut at a predetermined position are formed. Therefore, the bonding area of the second bonding portion 60b relative to the conductive pattern 50, 51, or 52 is large.

In a step illustrated in Fig. 12, the capillary 83 is raised and the wire 60 is cut.

As described above, in wire bonding, the wire 60 is firstly bonded onto the inner connection pad 41, secondly bonded onto the conductive pattern 50, 51, or 52, and then is cut. If the second bonding region onto which the wire 60 is secondly bonded is the inner connection pad 41, it is necessary to increase the size of the inner connection pad 41. However, in the present embodiment, since the inner connection pad 41 is the first bonding region onto which the wire 60 is firstly bonded, it is possible to reduce the size of the inner connection pad 41. This makes it possible to reduce the size of the first chip 22 and the second chip 23. Thus, the magnetoresistive elements 4 and 5 included in the chips 22 and 23 can be placed in a small area.

Although two chips are mounted on the substrate 21 in the present embodiment, the number of chips may be more than two. When the number of chips is more than two, the conductive patterns are not formed between adjacent chips, and are formed on the substrate 21 in the surrounding region outside the chips. Then again, first connection pads for electrically connecting the chips and the conductive patterns are wire-bonded to each other.

In the present embodiment, the connection pads include the inner connection pads 41 and the outer connection pads 42 illustrated in Fig. 1. The connection pads may be arranged in a manner different from that illustrated in Fig. 1. In the present embodiment, however, the first connection pads (inner connection pads) are arranged on facing sides of the chips electrically connected to each other. This is effectively applicable to a configuration in which the first connection pads and their corresponding conductive patterns are wire-bonded to each other, so that an electrical connection between the chips can be made.

The magnetic detecting elements formed in the chips may not necessarily be GMR elements, but may be tunnel magnetoresistive elements (TMR elements) or may be of other types. The GMR elements and TMR elements have a laminated structure as described with reference to Fig. 4 (while the TMR elements have an insulating layer in place of the nonmagnetic material layer 29). When one of the chips having the same chip configuration is turned 180 degrees from the orientation of the other chip and placed on the substrate 21 such that the magnetization directions 28a in the fixed magnetic layers 28 are antiparallel to each other, a rotating magnetic field can be detected with a large output value. Therefore, using GMR elements or TMR elements as magnetic detecting elements is preferable in that it is possible to make magnetic detecting devices that are capable of highly accurately detecting magnetic fields with a simple configuration.

### Brief Description of Drawings

[Fig. 1] Fig. 1 is a plan view of a magnetic detecting device according to the present embodiment.
[Fig. 2] Fig. 2 is a partial enlarged cross-sectional view taken along line A-A of Fig. 1 in a height direction of the magnetic detecting device, the view showing a cross section of the magnetic detecting device as viewed from the direction of arrows.
[Fig. 3] Fig. 3 illustrates a circuit configuration of the magnetic detecting device according to the present embodiment.
[Fig. 4] Fig. 4 is a partial enlarged cross-sectional view taken along line B-B of Fig. 1 in the height direction of the magnetic detecting device, the view showing a cross section of the magnetic detecting device as viewed from the direction of arrows.
[Fig. 5] Fig. 5(a) to Fig. 5(d) schematically illustrate magnetization directions in a fixed magnetic layer and a free magnetic layer of both a first magnetoresistive element and a second magnetoresistive element, the magnetization directions being associated with changes in direction of an external magnetic field.
[Fig. 6] Fig. 6 is a perspective view of an angle detecting apparatus according to the present embodiment.
[Fig. 7] Fig. 7 is a diagram (plan view) illustrating one step of a process of making the magnetic detecting device according to the present embodiment.
[Fig. 8] Fig. 8 is a diagram (plan view) illustrating one step performed following the step of Fig. 7.
[Fig. 9] Fig. 9 is a diagram (plan view) illustrating one step performed following the step of Fig. 8.
[Fig. 10] Fig. 10 is a diagram (enlarged side view) illustrating one step for explaining wire bonding according to the present embodiment.
[Fig. 11] Fig. 11 is a diagram (enlarged side view) illustrating one step performed following the step of Fig. 10.
[Fig. 12] Fig. 12 is a diagram (enlarged side view) illustrating one step performed following the step of Fig. 11.
[Fig. 13] Fig. 13 is a plan view of a conventional magnetic detecting device.

### Reference Numerals

- 20: magnetic detecting device
- 21: substrate
- 22: first chip
- 23: second chip
- 24: first magnetoresistive element
- 25: second magnetoresistive element
- 27: antiferromagnetic layer
- 28: fixed magnetic layer
- 29: nonmagnetic material layer
- 30: free magnetic layer
- 31: protective layer
- 32: first series circuit
- 33: second series circuit
- 34,: 35 output extracting portion
- 36: input terminal
- 37: ground terminal
- 38: differential amplifier
- 41: inner connection pad (first connection pad)
- 42: outer connection pad
- 50, 51, 52: conductive pattern
- 60, 61, 62, 63, 64: wire
- 60a: first bonding portion
- 60b: second bonding portion
- 70: angle detecting apparatus
- 71: magnetic-field generating member
- 80, 81: chip mounting region
- 82: gold ball
- 83: capillary
- D: facing region
- E: surrounding region
- H: external magnetic field

## Claims

1. A magnetic detecting device comprising a substrate and a plurality of chips mounted on the substrate, the chips each being provided with connection pads and magnetic detecting elements having an electrical characteristic changing in accordance with a magnetic field change, the magnetic detecting device being capable of detecting the magnetic field change on the basis of a change in the electrical characteristic,
wherein conductive patterns are formed on the substrate in a surrounding region outside the chips except for a region between the chips, the connection pads of each of the chips include first connection pads for electrically connecting the chips, the first connection pads are wire-bonded to their corresponding conductive patterns, and thereby the chips are electrically connected to each other.

2. The magnetic detecting device according to claim 1, wherein the first connection pads are arranged on facing sides of the chips electrically connected to each other.

3. The magnetic detecting device according to claim 1 or 2, wherein each wire for the wire bonding is bonded onto each of the first connection pads and its corresponding conductive pattern, and a region on the first connection pad is a first bonding region onto which the wire is firstly bonded and a region on the conductive pattern is a second bonding region onto which the wire is secondly bonded.

4. The magnetic detecting device according to any one of claims 1 to 3, wherein a pair of electrically-connected chips each include a magnetoresistive element using a magnetoresistive effect and having a fixed magnetic layer and a free magnetic layer that are stacked with a nonmagnetic material layer interposed therebetween, the fixed magnetic layer having a fixed magnetization direction, the free magnetic layer having a magnetization direction varying in accordance with an external magnetic field; and
the magnetization direction in the fixed magnetic layer of the magnetoresistive element in one of the chips is antiparallel to the magnetization direction in the fixed magnetic layer of the magnetoresistive element in the other chip.

5. An angle detecting apparatus comprising the magnetic detecting device according to any one of claims 1 to 4 and a magnetic-field generating member facing the magnetic detecting device in a height direction of the substrate and configured to generate an external magnetic field,
wherein at least one of the magnetic detecting device and the magnetic-field generating member is supported so as to be rotatable about a rotation axis extending in the height direction of the substrate; and
a rotation angle is detected on the basis of an output change associated with a magnetic field change detected by the magnetic detecting device.

6. A position detecting apparatus comprising the magnetic detecting device according to any one of claims 1 to 4 and a magnetic-field generating member facing the magnetic detecting device in a height direction of the substrate and configured to generate an external magnetic field,
wherein the magnetic detecting device has moving components in a direction orthogonal to the height direction and is supported movably relative to the magnetic-field generating member; and
a position of the magnetic detecting device relative to the magnetic-field generating member is detected on the basis of an output change associated with a magnetic field change detected by the magnetic detecting device.

7. A magnetic switch comprising the magnetic detecting device according to any one of claims 1 to 4 and a magnetic-field generating member facing the magnetic detecting device in a height direction of the substrate and configured to generate an external magnetic field,
wherein at least one of the magnetic detecting device and the magnetic-field generating member is supported such that a distance between the magnetic detecting device and the magnetic-field generating member is variable; and
an ON signal or an OFF signal is generated on the basis of an output change associated with a magnetic field change detected by the magnetic detecting device.

8. A method for making a magnetic detecting device including a substrate and a plurality of chips mounted on the substrate, the chips each being provided with connection pads and magnetic detecting elements having an electrical characteristic changing in accordance with a magnetic field change, the magnetic detecting device being capable of detecting the magnetic field change on the basis of a change in the electrical characteristic, the method comprising the steps of:
(a) forming conductive patterns on the substrate in a surrounding region outside chip mounting regions, except for a region between the chip mounting regions;
(b) mounting the chips on their corresponding chip mounting regions; and
(c) electrically connecting the chips by wire-bonding first connection pads to their corresponding conductive patterns, the first connection pads being included in the connection pads of each of the chips and provided for electrically connecting the chips.

9. The method according to claim 8, wherein, in the wire bonding in the step (c), each wire is firstly bonded onto one of the first connection pads, secondly bonded onto the conductive pattern corresponding to the first connection pad, and cut.

## Amended claims

### Amended claims under Art. 19.1 PCT

**1.** (Amended) A magnetic detecting device comprising a substrate and a plurality of chips mounted on the substrate, the chips each being provided with connection pads and magnetic detecting elements having an electrical characteristic changing in accordance with a magnetic field change, the magnetic detecting device being capable of detecting the magnetic field change on the basis of a change in the electrical characteristic,
wherein conductive patterns are formed on the substrate in a surrounding region outside the chips except for a region between the chips, the connection pads of each of the chips include first connection pads for electrically connecting the chips, the first connection pads are wire-bonded to their corresponding conductive patterns, and thereby the chips are electrically connected to each other; and
the conductive patterns include a conductive pattern formed around a part of the surrounding region such that a connection portion connected to one of the chips and a connection portion connected to the other chip are formed in regions facing each other, with the chips interposed therebetween.

**2.** The magnetic detecting device according to claim 1, wherein the first connection pads are arranged on facing sides of the chips electrically connected to each other.

**3.** The magnetic detecting device according to claim 1 or 2, wherein each wire for the wire bonding is bonded onto each of the first connection pads and its corresponding conductive pattern, and a region on the first connection pad is a first bonding region onto which the wire is firstly bonded and a region on the conductive pattern is a second bonding region onto which the wire is secondly bonded.

**4.** The magnetic detecting device according to any one of claims 1 to 3, wherein a pair of electrically-connected chips each include a magnetoresistive element using a magnetoresistive effect and having a fixed magnetic layer and a free magnetic layer that are stacked with a nonmagnetic material layer interposed therebetween, the fixed magnetic layer having a fixed magnetization direction, the free magnetic layer having a magnetization direction varying in accordance with an external magnetic field; and
the magnetization direction in the fixed magnetic layer of the magnetoresistive element in one of the chips is antiparallel to the magnetization direction in the fixed magnetic layer of the magnetoresistive element in the other chip.

**5.** (Amended) The magnetic detecting device according to any one of claims 1 to 4, wherein a first chip and a second chip are mounted on the substrate, and the first chip and the second chip each have the first connection pads being inner connection pads arranged on a side facing the other chip and outer connection pads arranged on a side opposite the first connection pads;
the first connection pads are used for electrically connecting the first chip and the second chip; and
the outer connection pads each are connected to any of an input terminal, a ground terminal, and an output extracting portion.

**6.** (Amended) The magnetic detecting device according to claim 5, wherein the first chip has two magnetic detecting elements spaced apart in parallel in a direction orthogonal to a direction in which the chips are arranged, the first connection pads are connected to their corresponding inner ends of the respective magnetoresistive elements, the inner ends facing the second chip, and the outer connection pads are provided at their corresponding outer ends of the respective magnetoresistive elements;
another first connection pad is extracted from one of the magnetic detecting elements, and another outer connection pad is extracted from the other magnetic detecting element; and
the magnetic detecting device has a chip configuration in which the second chip is turned 180 degrees from an orientation of the first chip.

**7.** (Amended) The magnetic detecting device according to any one of claims 1 to 6, wherein the chips each have the same number of plurality of first connection pads, and first connection pads of adjacent chips, the first connection pads facing in a direction in which the chips are arranged, are electrically connected to each other through their corresponding conductive patterns.

**8.** (Amended) An angle detecting apparatus comprising the magnetic detecting device according to any one of claims 1 to 7 and a magnetic-field generating member facing the magnetic detecting device in a height direction of the substrate and configured to generate an external magnetic field,
wherein at least one of the magnetic detecting device and the magnetic-field generating member is supported so as to be rotatable about a rotation axis extending in the height direction of the substrate; and
a rotation angle is detected on the basis of an output change associated with a magnetic field change detected by the magnetic detecting device.

**9.** (Amended) A position detecting apparatus comprising the magnetic detecting device according to any one of claims 1 to 7 and a magnetic-field generating member facing the magnetic detecting device in a height direction of the substrate and configured to generate an external magnetic field,
wherein the magnetic detecting device has moving components in a direction orthogonal to the height direction and is supported movably relative to the magnetic-field generating member; and
a position of the magnetic detecting device relative to the magnetic-field generating member is detected on the basis of an output change associated with a magnetic field change detected by the magnetic detecting device.

**10.** (Added) A magnetic switch comprising the magnetic detecting device according to any one of claims 1 to 7 and a magnetic-field generating member facing the magnetic detecting device in a height direction of the substrate and configured to generate an external magnetic field,
wherein at least one of the magnetic detecting device and the magnetic-field generating member is supported such that a distance between the magnetic detecting device and the magnetic-field generating member is variable; and
an ON signal or an OFF signal is generated on the basis of an output change associated with a magnetic field change detected by the magnetic detecting device.

**11.** (Added) A method for making a magnetic detecting device including a substrate and a plurality of chips mounted on the substrate, the chips each being provided with connection pads and magnetic detecting elements having an electrical characteristic changing in accordance with a magnetic field change, the magnetic detecting device being capable of detecting the magnetic field change on the basis of a change in the electrical characteristic, the method comprising the steps of:
(a) forming conductive patterns on the substrate in a surrounding region outside chip mounting regions, except for a region between the chip mounting regions;
(b) mounting the chips on their corresponding chip mounting regions; and
(c) electrically connecting the chips by wire-bonding first connection pads to their corresponding conductive patterns, the first connection pads being included in the connection pads of each of the chips and provided for electrically connecting the chips.

**12.** (Added) The method according to claim 11, wherein, in the wire bonding in the step (c), each wire is firstly bonded onto one of the first connection pads, secondly bonded onto the conductive pattern corresponding to the first connection pad, and cut.
